# FASCICULE DE BREVET EUROPEEN

(11) **EP 3 042 446 B1**
(45) Date de publication et mention de la délivrance du brevet: **12.08.2020**
(21) Numéro de dépôt: 14755823.3
(22) Date de dépôt: 27.08.2014
(51) Int. Cl.: H03H 7/40, H04B 1/04, H04B 1/18

(54) **PROCEDE D'ADAPTATION AUTOMATIQUE D'IMPEDANCE ET CHAINE D'EMISSION CORRESPONDANTE**
VERFAHREN ZUR AUTOMATISCHEN IMPEDANZANPASSUNG UND ENTSPRECHENDER ÜBERTRAGUNGSKANAL
METHOD FOR AUTOMATIC IMPEDANCE MATCHING AND CORRESPONDING TRANSMISSION CHANNEL

(30) Priorité: 04.09.2013 FR 1358471
(43) Date de publication de la demande: 13.07.2016
(73) Titulaire: Commissariat à l'Energie Atomique et aux Energies Alternatives, 75015 Paris (FR)
(72) Inventeur: GONZALEZ JIMENEZ, Jose Luis, F-38340 Voreppe (FR)
(74) Mandataire: Priori, Enrico
(86) Numéro de dépôt international: PCT/EP2014/068159
(87) Numéro de publication internationale: WO 2015/032669

(56) Documents cités:
- US-A- 4 704 573
- US-A1- 2011 269 416
- US-A1- 2012 075 016
- US-A1- 2012 313 710
- NATHALIE DELTIMPLE ET AL: "Design of a fully integrated CMOS self-testable RF power amplifier using a thermal sensor", ESSCIRC (ESSCIRC), 2012 PROCEEDINGS OF THE, IEEE, 17 septembre 2012 (2012-09-17), pages 398-401, XP032466466, DOI: 10.1109/ESSCIRC.2012.6341278 ISBN: 978-1-4673-2212-6
- Mikel Martìn; Gonzalez Jiménez José Luis: "RECERCAT - Excerpt: Depòsit de la Recerca de Catalunya 1", , 5 novembre 2012 (2012-11-05), XP055161099, Extrait de l'Internet: URL:http://www.recercat.net/handle/2072/19 4702 [extrait le 2015-01-09]
- Mikel Martìn; Gonzalez Jiménez José Luis: "RECERCAT - Excerpt: Depòsit de la Recerca de Catalunya 2", , 5 novembre 2012 (2012-11-05), pages 1-6, XP055161330, Extrait de l'Internet: URL:http://www.recercat.net/handle/2072/19 4702 [extrait le 2015-01-12]

## Description

L'invention concerne un procédé pour faciliter l'adaptation d'impédance de circuits radiofréquence, notamment de circuits d'émission utilisant un amplificateur de puissance relié à une charge qui peut comprendre une antenne.

Dans certaines applications de transmission d'informations en radiofréquence, on a constaté que l'antenne d'émission ou de réception pouvait avoir une impédance dépendant fortement de conditions extérieures à l'antenne, et dépendant notamment du milieu dans lequel l'antenne est placée.

Par exemple, dans la télémétrie médicale, on peut être amené à introduire l'antenne dans une sonde placée dans le corps humain, et l'impédance dépend alors fortement du milieu biologique dans lequel l'antenne se trouve. Elle dépend des propriétés électriques (conductivité, constante diélectrique) des tissus environnants (muscles, graisse) ou du milieu liquide (sang, autres liquides) dans lequel l'antenne peut être immergée.

Même dans des applications plus conventionnelles de transmission radiofréquence (téléphonie mobile, etc.) l'impédance de l'antenne peut varier.

De manière générale, les variations d'impédance d'antenne sont particulièrement sensibles pour des antennes de très petites dimensions ayant un fort coefficient de qualité, utilisées dans les applications à fortes contraintes de miniaturisation.

Ces variations d'impédance peuvent entraîner des pertes dites pertes de désadaptation : ces pertes résultent de ce que la chaîne d'émission qui alimente l'antenne, ou la chaîne de réception qui reçoit un signal de l'antenne, est en général conçue pour avoir des performances optimales lorsqu'elle est chargée (en sortie pour la chaîne d'émission ou en entrée pour la chaîne de réception) par une impédance nominale bien déterminée ; elle a des performances dégradées lorsqu'elle est chargée par une impédance différente de sa valeur nominale. Les pertes de désadaptation peuvent aller jusqu'à 40 dB.

C'est pourquoi on a déjà essayé d'interposer entre la sortie de la chaîne d'émission et l'antenne d'émission (et on pourrait le faire aussi en entrée pour une antenne de réception) un réseau d'adaptation d'impédance, en anglais « matching network », qui fait que la chaîne d'émission voit une impédance différente de celle de l'antenne et de préférence égale à la valeur nominale pour laquelle elle a été conçue, par exemple 100 ohms ou 500 ohms. Le réseau d'adaptation est accordable, c'est-à-dire que ses éléments, capacitifs et/ou inductifs, ont des valeurs ajustables pour tenir compte des conditions d'environnement de l'antenne de telle sorte que l'adaptation soit la meilleure possible quelles que soient les circonstances.

Le document US 2012/0075016 divulgue un appareil et un procédé d'adaptation d'impédance, dans lequel l'adaptation est obtenue en ajustant les valeurs d'impédance de deux éléments (par exemple des condensateurs variables) en fonction d'une valeur de tension mesurée par un détecteur de pic. Une mesure de température permet d'introduire une correction des valeurs d'impédance ainsi déterminées.

Le document US 2011/0269416 enseigne l'utilisation d'une mesure de température, associée à une information relative à une bande spectrale, pour effectuer un ajustement préliminaire des impédances d'un circuit d'adaptation, suivi d'un ajustement fin qui ne met pas en œuvre une mesure de température. L'ajustement préliminaire des impédances utilise une simple table de correspondance.

Dans la demande de brevet US 2009-0066440, on a proposé un procédé d'adaptation automatique d'impédance dans une chaîne d'émission ou de réception, dans lequel on détecte à la fois l'amplitude et la phase du courant et de la tension en sortie de la chaîne d'émission (ou en entrée de la chaîne de réception). Le rapport entre la tension et le courant est représentatif de l'impédance de charge Zm vue par la chaîne chargée par l'ensemble du réseau d'adaptation et de l'antenne d'impédance Zant. On mesure l'impédance de charge Zm et on calcule l'impédance d'antenne Zant à partir de l'impédance de charge mesurée Zm et des impédances du réseau d'adaptation dont la configuration est connue au moment de la mesure, et enfin on calcule la modification qu'il faut appliquer à une ou plusieurs des impédances du réseau d'adaptation, pour obtenir que l'impédance vue par l'amplificateur devienne adaptée à l'impédance nominale de l'amplificateur dans les conditions actuelles d'environnement de l'antenne.

Le document US 4,704,573 divulgue un circuit permettant de déterminer si l'impédance d'une charge se trouve à l'intérieur ou à l'extérieur d'un cercle sur l'abaque de Smith, caractérisé par son centre et son rayon, qui peuvent dépendre de la température d'un amplificateur alimentant la charge. Dans ce document, comme dans US 6,965,837, on utilise un circuit de détection placé entre l'amplificateur et la charge pour mesurer la puissance du signal en deux endroits différents et en déduire les pertes donc la qualité plus ou moins bonne de l'adaptation.

Le document US2012/0313710 enseigne des modes de réalisation d'un circuit et d'un procédé correspondant pour mesurer la température de jonction d'un amplificateur de puissance et utiliser la mesure pour permettre l'optimisation des performances en présence d'une charge non-adaptée via la commande de l'amplificateur de puissance de telle sorte s'une action corrective pour atténuer les effets de la charge non-adaptée puisse être effectuée.

Ces solutions demandent un contact électrique ou un couplage électromagnétique à la sortie de l'amplificateur, ce qui peut dégrader les performances de celui-ci ou les performances du réseau d'adaptation placé en aval de l'amplificateur.

De manière générale, les circuits de détection de désadaptation influent eux-mêmes sur les conditions d'adaptation, ce qui complique beaucoup leur conception : il faut concevoir en même temps le circuit de détection, le circuit d'adaptation, et l'amplificateur pour éviter l'influence du circuit de détection sur l'adaptation.

Selon l'invention, on propose un procédé différent pour aider à l'adaptation d'impédance de la chaîne d'émission.

Au lieu de détecter des amplitudes de signaux électriques ou des champs électromagnétiques, on propose de mesurer la température au voisinage de l'amplificateur, pour constater, en cas d'augmentation anormale, une désadaptation d'impédance et pour corriger cette désadaptation dans un sens tendant à ramener la température à une valeur de référence correspondant à une adaptation d'impédance correcte.

Une bonne adaptation d'impédance correspond par principe à un transfert optimal de puissance de l'amplificateur vers la charge. Le rapport entre la puissance transmise à la charge et la puissance dissipée par l'amplificateur est alors maximal. Ce rapport se réduit lorsqu'il y a désadaptation, et l'amplificateur se met à dissiper une puissance plus importante.

Cette variation de puissance dissipée peut être observée indirectement par une variation de température à proximité immédiate de l'amplificateur (et plus précisément des transistors de l'étage de sortie de l'amplificateur). Un détecteur de température est donc placé à cet endroit sur le circuit intégré qui contient l'amplificateur.

Pour différentes impédances de charge on peut déterminer la température qui en résulte et qui est donnée par le détecteur. En opération, la mesure de la température fournira une indication du degré de désadaptation de l'impédance de charge actuelle. On pourra dès lors remédier à cette désadaptation en agissant sur le réseau d'adaptation inséré entre l'amplificateur et la charge (une antenne radiofréquence par exemple).

Accessoirement, en mode de test et en plaçant des impédances de charge connues en sortie de l'amplificateur, on pourra vérifier que l'amplificateur fonctionne correctement pour ces différentes charges, une température anormale pour une charge donnée indiquant un mauvais fonctionnement.

Cette technique de contrôle de l'adaptation d'impédance ne nécessite pas de contact électrique ou de couplage électromagnétique ; elle n'a pas d'incidence sur le fonctionnement de l'amplificateur ou de son réseau d'adaptation.

Les variations de température sont bien entendu à basse fréquence (quelques kilohertz au maximum) et elles permettent de surveiller le fonctionnement d'un amplificateur travaillant à des fréquences radio (à partir de quelques MHz et jusqu'à plusieurs GHz).

Ainsi, on propose selon l'invention un procédé d'adaptation d'impédance d'une chaîne d'émission comprenant un étage amplificateur de sortie relié à une charge par l'intermédiaire d'un réseau d'adaptation d'impédance comprenant des impédances variables, le procédé comportant les pas suivants :
on produit un signal de mesure de la température engendrée par le fonctionnement de l'étage amplificateur de sortie, au moyen d'un circuit de mesure comprenant un détecteur de température placé à proximité immédiate de cet étage,
on fournit le signal de mesure en entrée d'un circuit de commande des impédances variables du réseau d'adaptation, et
on utilise ledit circuit de commande pour faire varier les valeurs desdites impédances variables en exécutant un algorithme de recherche de valeurs desdits impédances tendant à minimiser la température détectée, ledit algorithme étant choisi parmi :
   - une exploration systématique de toutes les valeurs possibles des impédances variables du réseau d'adaptation d'impédance et une observation de l'échauffement de l'étage amplificateur de sortie à chaque fois ; et
   - un algorithme d'optimisation complexe.

Une chaîne d'émission selon l'invention comporte au moins un étage amplificateur de sortie, une charge, et un réseau d'adaptation d'impédance placé entre l'étage amplificateur et la charge et comportant des impédances variables, un circuit de mesure comportant un détecteur de température placé sur un circuit intégré comportant l'étage amplificateur de sortie, à proximité immédiate de cet étage de sortie, ainsi qu'un circuit de commande du réseau d'adaptation, ledit circuit de commande étant configuré pour recevoir en entrée un signal de mesure de température généré par ledit circuit de mesure et pour faire varier les valeurs desdites impédances variables dudit réseau d'adaptation d'impédance en exécutant un algorithme de recherche de valeurs desdits impédances tendant à minimiser la température détectée, ledit algorithme étant choisi parmi :
- une exploration systématique de toutes les valeurs possibles des impédances variables du réseau d'adaptation d'impédance et une observation de l'échauffement de l'étage amplificateur de sortie à chaque fois ; et
- un algorithme d'optimisation complexe.

De préférence, on utilise deux détecteurs de température placés sur le circuit intégré, l'un à proximité immédiate de l'étage de sortie et l'autre plus loin. Le deuxième détecteur fournit une information de température moyenne de la puce de circuit intégré, pour fournir une référence par rapport à laquelle les variations de température du premier détecteur peuvent être analysées. Les moyens de commande du circuit d'adaptation d'impédance agissent alors en fonction de la différence entre les températures fournies par les deux détecteurs.

Le réseau d'adaptation peut être constitué d'un montage simple à trois impédances réactives en Té ou en Pi, par exemple une capacité et deux inductances ou une inductance et deux capacités. Au moins une de ces impédances est variable, et de préférence deux des impédances seront variables. De préférence, on utilisera deux capacités variables et une inductance fixe. Le réseau d'adaptation peut aussi avoir plusieurs étages en cascade.

D'autres caractéristiques et avantages de l'invention apparaîtront à la lecture de la description détaillée qui suit et qui est faite en référence aux dessins annexés dans lesquels :
- la figure 1 représente le schéma de principe de l'invention ;
- la figure 2 représente un perfectionnement avec deux détecteurs de température ;
- la figure 3 représente un circuit de détection de température utilisable dans le procédé selon l'invention ;
- la figure 4 représente un amplificateur de puissance auquel l'invention peut être appliquée ; et
- les figures 5A et 5B illustrent une validation expérimentale du principe de l'invention.

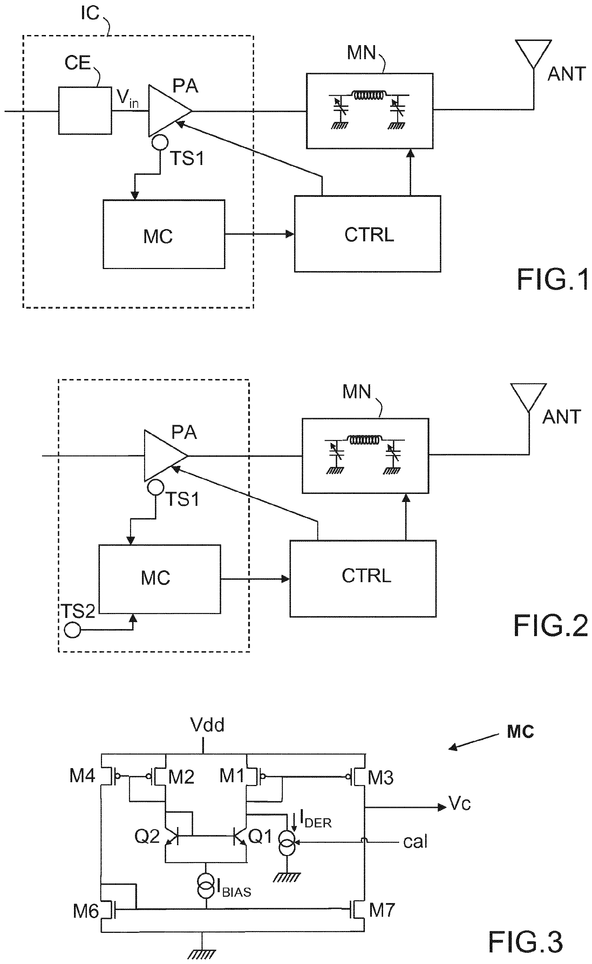

La figure 1 représente le schéma de principe de l'invention. L'exemple typique auquel l'invention s'applique est une chaîne d'émission radiofréquence dont l'étage de sortie comprend un amplificateur de puissance PA recevant des signaux Vᵢₙ à amplifier et alimentant une charge qui peut être une antenne ANT. L'amplificateur de l'étage de sortie est conçu pour fonctionner de manière optimale lorsque la charge placée à sa sortie a une impédance nominale Zₒₚₜ et lorsque la fréquence de fonctionnement est F₀, correspondant à une pulsation ω₀ = 2π.F₀. A haute fréquence, l'impédance Zₒₚₜ sera généralement complexe et fonction de la fréquence.

Un réseau d'adaptation MN est inséré en série entre la sortie de l'amplificateur PA et l'antenne ANT. Ce schéma pourrait aussi inclure un filtre entre l'amplificateur PA et le réseau MN et/ou un filtre entre le réseau MN et l'antenne. Le réseau d'adaptation est constitué par des inductances et capacités dont certaines valeurs (de préférence des valeurs de capacités) sont ajustables.

Le réseau d'adaptation MN a pour but de faire en sorte que l'impédance de la charge de l'amplificateur soit égale à l'impédance optimale Zₒₚₜ de l'amplificateur ou la plus proche possible de cette impédance optimale. La charge de l'amplificateur est essentiellement constituée par le réseau MN, lui-même chargé par l'antenne ANT.

La réalisation la plus simple du réseau d'adaptation est un circuit à trois impédances réactives en Té ou en Pi, par exemple une capacité et deux inductances ou mieux une inductance et deux capacités. Au moins une de ces impédances est variable, mais en pratique deux des impédances seront variables. De préférence, on utilisera deux capacités variables et une inductance fixe en considérant qu'il est plus facile de réaliser des capacités variables précises que des inductances variables. Le réseau d'adaptation peut aussi avoir plusieurs étages en cascade si la désadaptation risque d'être particulièrement forte. Dans ce cas, chaque étage peut être constitué par un montage simple à trois impédances réactives en Té ou en Pi avec en principe deux impédances réactives variables dans chaque étage.

Un circuit de commande CTRL permet de modifier les impédances du réseau d'adaptation. Il agit pour imposer des valeurs désirées aux impédances variables du circuit. Par exemple, si les impédances variables sont des capacités, on peut prévoir que le réseau comporte plusieurs capacités de valeurs différentes ; le circuit de commande CTRL agit alors pour sélectionner une capacité parmi les capacités disponibles. Ou encore, une capacité de valeur ajustable peut être formée par la mise en parallèle de plusieurs capacités dont les valeurs représentent des poids différents, le circuit de commande agit pour sélectionner celles des capacités qu'il faut mettre en parallèle pour obtenir une valeur désirée. Une capacité variable peut aussi être réalisée par un élément commandable par une tension électrique (diode varactor par exemple).

Le circuit de commande CTRL agit sous la commande d'un circuit de mesure MC qui reçoit une information d'un détecteur de température TS1 placé physiquement à proximité immédiate de l'amplificateur de puissance PA. Le circuit de mesure fournit une information sur les variations de température locales engendrées par l'amplificateur. L'amplificateur de puissance est formé dans un circuit intégré IC, de même que les différents circuits de traitement CE qui fournissent à l'amplificateur PA un signal d'entrée radiofréquence à amplifier. Le détecteur de température TS1 est placé dans ce circuit intégré et près des transistors de sortie de l'amplificateur de manière à réagir dès que possible aux variations de température dues au fonctionnement de l'amplificateur.

Le réseau d'adaptation MN et le circuit de contrôle CTRL ne font pas nécessairement partie du circuit intégré ; ils ont été représentés en dehors de la puce de circuit intégré IC.

Un échauffement anormalement élevé de l'amplificateur produit une augmentation anormale de température à proximité de l'amplificateur PA ; cette augmentation est le signe d'une désadaptation possible de l'amplificateur. En effet cette désadaptation se traduit par une puissance consommée trop élevée par rapport à la puissance transmise, donc des pertes de puissance anormales au niveau de l'amplificateur.

Les variations de température sont bien entendu des variations lentes qui ne sont pas affectées par une modulation à haute fréquence due au signal amplifié lui-même, même si la distance entre les éléments de puissance qui dissipent la chaleur et le détecteur de température est très faible (quelques dizaines ou centaines de micromètres par exemple).

Le circuit de contrôle CTRL reçoit du circuit de mesure MC une information représentant la température au voisinage de l'amplificateur de l'étage de sortie ; il exécute un algorithme de recherche tendant à minimiser la température. Cet algorithme consiste tout simplement en une exploration systématique de toutes les valeurs possibles des impédances variables du réseau MN et une observation de l'échauffement à chaque fois. Le circuit prend alors une décision sur le choix de valeurs d'impédances variables qui minimise l'échauffement de l'amplificateur, en valeur absolue s'il n'y a qu'un détecteur de température TS1, en différentiel s'il y a deux détecteurs TS1 et TS2 à distance l'un de l'autre.

L'amplificateur PA peut fonctionner en classe A pour que la puissance consommée ne dépende pas du niveau de signal amplifié. Sinon, on effectue l'algorithme de recherche d'adaptation optimale en mode de calibration préalable, avec un niveau de signal d'entrée constant.

De préférence, comme représenté à la figure 2, le circuit de mesure MC utilise deux détecteurs de température placés sur le circuit intégré, l'un (TS1) à proximité immédiate de l'amplificateur de puissance, l'autre (TS2) loin de l'amplificateur, à un endroit où les variations de dissipation de l'amplificateur n'influent pas ou n'influent que très lentement sur la température locale. Le circuit de mesure MC est alors un circuit différentiel qui fournit un signal qui est une fonction (de préférence, une fonction proportionnelle) de la différence entre la température locale de l'étage amplificateur, mesurée par le détecteur TS1, et la température moyenne de la puce de circuit intégrée, mesurée par le détecteur TS2. Ainsi, le signal fourni par le circuit de mesure ne dépend pas des conditions de température liées à l'environnement, mais seulement du fonctionnement propre de la chaîne d'émission.

La figure 3 représente un exemple de circuit de mesure MC fonctionnant de manière différentielle avec deux transistors NPN Q1 et Q2 qui constituent respectivement les deux détecteurs de température TS1 et TS2. Les transistors Q1 et Q2 sont placés physiquement à distance l'un de l'autre dans le circuit intégré, comme expliqué en référence à la figure 2, la figure 3 représentant seulement le principe du schéma électrique des connexions des différents éléments. Les transistors Q1 et Q2 sont montés dans deux branches différentielles alimentées par un courant commun I_{BIAS}. Les deux transistors ont leurs bases reliées entre elles et leurs émetteurs reliés entre eux. Les caractéristiques courant-tension des transistors varient en fonction de la température, de sorte que pour une même tension base-émetteur, les courants de collecteur des deux transistors sont différents si leurs températures sont différentes, la somme de ces courants restant constante. Le transistor Q2 est monté en diode, c'est-à-dire que sa base est reliée à son collecteur.

La charge en série avec le collecteur du transistor Q2 est un transistor PMOS M2 monté en diode (collecteur et base reliés). Le courant du transistor M2 est recopié par un transistor PMOS M4 qui alimente un transistor NMOS M6 monté en diode. Le courant du transistor M6 est recopié par un transistor NMOS M7.

De manière similaire, la charge de collecteur du transistor Q1 est un transistor PMOS M1 qui est monté en diode. Le courant du transistor M1 est recopié par un transistor PMOS M3 qui est en série avec le transistor M7. Le point de jonction des transistors M3 et M7 constitue la sortie du circuit de surveillance. Il fournit une tension de commande Vc représentant le déséquilibre des courants passant dans les transistors Q1 et Q2, donc le déséquilibre des températures des deux transistors. Cette tension de commande représente l'information de température (ici une information différentielle).

La courbe de réponse de ce circuit de mesure (courbe de la tension de sortie Vc en fonction de la différence de température T1-T2 entre les deux points de mesure) peut être ajustée en dérivant vers la masse un courant I_{DER} du collecteur du transistor Q1. Le réglage de ce courant de dérivation I_{DER} par un signal de calibration (cal) permet de modifier la plage de différences de température dans laquelle le circuit fournit une réponse sensiblement linéaire en fonction de la différence de température. La réponse linéaire est par exemple d'environ 0,2V/°C dans la plage où T1-T2 va de 2 à 5° pour une certaine valeur de I_{DER} et de 0,2V/°C dans la plage de 5 à 8°C pour une autre valeur de I_{DER}. La source de courant de dérivation peut être un simple transistor NMOS, le réglage du courant étant fait par l'ajustement de la tension appliquée entre la grille et la source du transistor.

Le circuit de mesure de la figure 3 est donné simplement à titre d'exemple, d'autres circuits pourraient aussi donner une tension ou un courant fonction d'une différence de température existant entre deux points du circuit intégré.

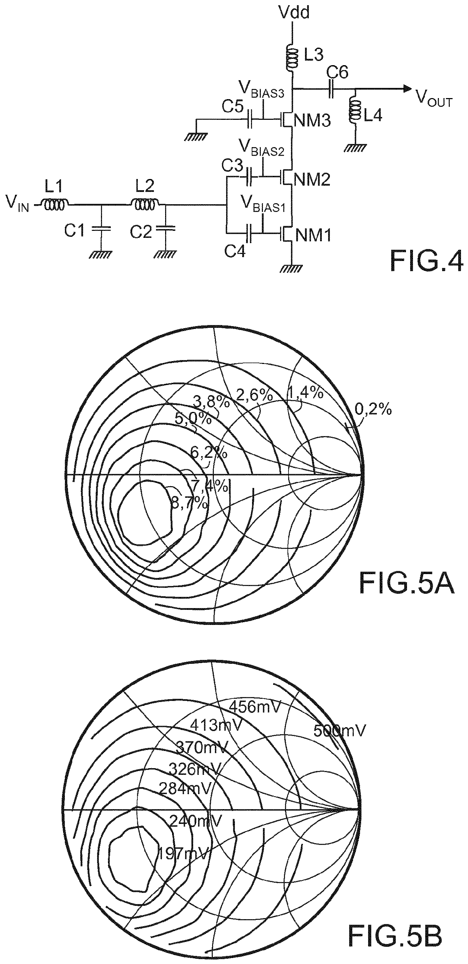

La figure 4 représente un exemple d'amplificateur de puissance radiofréquence PA auquel l'invention peut être appliquée. Cet amplificateur est décrit en détail dans l'article de N. Deltimple, J.L. Gonzalez, J. Altet, Y. Luque et E. Kerherve, « Design of a fully integrated CMOS self-testable RF power amplifier using a thermal sensor » Proceedings of the ESSCIRC 2012, 17-21 Sept. 2012, pp. 398-401.

L'amplificateur comprend un filtre d'entrée qui est un filtre passe-bande dans la gamme de fréquence à amplifier ; le filtre est constitué dans cet exemple par deux inductances L1 et L2 en série, deux capacités C1 et C2 reliant à la masse les extrémités de l'inductance L2, et deux capacités de découplage C3 et C4. L'impédance d'entrée vue de l'entrée de ce filtre est de 50 ohms et la tension à amplifier est appliquée à l'entrée V_{IN} du filtre. Les capacités de découplage C3 et C4, reliées d'un côté à l'inductance L2 et à la capacité C2, sont reliées par ailleurs respectivement aux grilles de deux transistors NMOS NM1 et NM2. Ces transistors sont en série. Leurs grilles sont polarisées par des tensions de polarisation continues V_{BIAS1} et V_{BIAS2}. L'ensemble en série des transistors NM1 et NM2 est en série également avec un transistor cascode NMOS NM3 dont la grille est polarisée par une tension continue V_{BIAS3}, et avec une inductance L3 reliée à une tension d'alimentation Vdd. Le transistor NM3 joue un rôle de translateur de niveau. La grille de NM3 peut être reliée à la masse par l'intermédiaire d'une capacité de découplage C5. Le point de jonction entre le drain du transistor NM3 et l'inductance L3 est relié à un ensemble en série d'une capacité C6 et d'une inductance L4 reliée à la masse. La sortie V_{OUT} de cet étage de puissance, filtrée par le filtre passe-haut C6, L4, est prise au point de jonction entre la capacité C6 et l'inductance L4. L'impédance de sortie de cet étage de puissance est de 50 ohms.

Le détecteur de température TS1 représenté à la figure 2 et qui peut être le transistor Q1 de la figure 3 est placé physiquement à proximité immédiate des transistors NM1 et NM2. Le détecteur de température TS2 est placé en un autre endroit de la puce de circuit intégré, loin des transistors NM1 et NM2.

Le principe de l'invention a été testé en reliant la sortie de l'amplificateur PA de la figure 4 à une impédance variable, modélisant l'effet de la modification d'un réseau d'adaptation MN en présence d'une impédance d'antenne fixe.

La figure 5A est un abaque de Smith normalisé par rapport à une impédance de 50 Ohm sur lequel sont tracées des courbes, approximativement circulaires, correspondant à des valeurs respectives d'efficience de l'amplificateur. En d'autre termes, chaque courbe est obtenue en reliant entre eux des points qui représentent des valeurs d'impédance de charge conduisant à une même efficience de l'amplificateur. La courbe la plus interne correspond à la meilleure adaptation d'impédance, et donc à l'efficience la plus élevée (8,7%).

La figure 5B est un abaque de Smith, également normalisé par rapport à une impédance de 50 Ohm, sur lequel sont tracées des courbes, approximativement circulaires, correspondant à des valeurs respectives de tension à la sortie du détecteur de température TS1. En d'autre termes, chaque courbe est obtenue en reliant entre eux des points qui représentent des valeurs d'impédance de charge conduisant à une même température mesurée. La courbe la plus interne correspond à la plus faible tension de sortie du détecteur (197 mV), et donc à la plus faible température mesurée.

On peut vérifier, par comparaison entre les figures 5A et 5B, que la meilleure efficience est atteinte pour les valeurs d'impédance qui minimisent la température mesurée, ce qui valide le principe à la base de l'invention. Par ailleurs, la figure 5B montre que la température est une fonction convexe de l'impédance complexe, ce qui permet d'appliquer des algorithmes bien connus d'optimisation convexe pour réaliser l'adaptation d'impédance.

## Revendications

1. Procédé d'adaptation d'impédance d'une chaîne d'émission comprenant un étage amplificateur de sortie relié à une charge par l'intermédiaire d'un réseau d'adaptation d'impédance (MN) comprenant des impédances variables, le procédé comprenant les pas suivants :
on produit un signal de mesure de la température engendrée par le fonctionnement de l'étage amplificateur de sortie, au moyen d'un détecteur de température (TS1) placé a proximité immédiate de cet étage, on fournit le signal de mesure en entrée d'un circuit (CTRL) de commande des impédances variables du réseau d'adaptation, et on utilise ledit circuit de commande pour faire varier les valeurs desdites impédances variables en exécutant un algorithme de recherche de valeurs desdites impédances tendant à minimiser la température détectée, ledit algorithme étant choisi parmi :
- une exploration systématique de toutes les valeurs possibles des impédances variables du réseau d'adaptation d'impédance et une observation de l'échauffement de l'étage amplificateur de sortie à chaque fois ; et
- un algorithme d'optimisation convexe.

2. Procédé selon la revendication 1, **caractérisé en ce qu'**on utilise deux détecteurs de température placés sur un circuit intégré qui contient l'étage amplificateur de sortie, l'un (TS1) à proximité immédiate de cet étage et l'autre (TS2) plus loin, pour fournir le signal de mesure, ce dernier représentant la différence entre la température locale de l'étage amplificateur et la température moyenne du circuit intégré.

3. Chaîne d'émission comportant au moins un étage amplificateur de sortie, une charge, et un réseau d'adaptation d'impédance placé entre l'étage amplificateur et la charge et comportant des impédances variables, un circuit de mesure comportant un détecteur de température (TS1) placé sur un circuit intégré comportant l'étage amplificateur de sortie, à proximité immédiate de cet étage de sortie, ainsi qu'un circuit de commande (CTRL) du réseau d'adaptation, ledit circuit de commande étant configuré pour recevoir en entrée un signal de mesure de température généré par ledit circuit de mesure et pour faire varier les valeurs desdites impédances variables dudit réseau d'adaptation d'impédance en exécutant un algorithme de recherche de valeurs desdites impédances tendant à minimiser la température mesurée, ledit algorithme étant choisi parmi :
- une exploration systématique de toutes les valeurs possibles des impédances variables du réseau d'adaptation d'impédance et une observation de l'échauffement de l'étage amplificateur de sortie à chaque fois ; et
- un algorithme d'optimisation convexe.

4. Chaîne d'émission selon la revendication 3 , **caractérisée en ce qu'**elle comporte un deuxième détecteur de température (TS2) placé sur le même circuit intégré et éloigné de l'étage de sortie, le circuit de mesure fournissant un signal représentant la différence des températures détectées par les deux détecteurs.

5. Chaîne d'émission selon l'une des revendications 3 et 4, **caractérisée en ce que** le réseau d'adaptation est constitué par un montage simple à trois impédances réactives en Té ou en Pi, dont l'une au moins est variable.

## Patentansprüche

1. Verfahren zur Impedanzanpassung einer Sendekette, beinhaltend eine Ausgangsverstärkerstufe, welche mit einer Last über ein Impedanzanpassungs-Netzwerk (MN) verbunden ist, welches variable Impedanzen beinhaltet, wobei das Verfahren folgende Schritte beinhaltet:
man erzeugt ein Messsignal der Temperatur, welche durch den Betrieb der Ausgangsverstärkerstufe erzeugt wird, mithilfe eines Temperaturdetektors (TS1), welcher in unmittelbarer Nähe dieser Stufe platziert ist, man stellt das Messsignal am Eingang einer Steuerschaltung (CTRL) der variablen Impedanzen des Anpassungs-Netzwerks bereit, und man verwendet die Steuerschaltung, um die Werte der variablen Impedanzen zum Variieren zu veranlassen, indem man einen Suchalgorithmus von Werten der Impedanzen ausführt, welcher dazu tendiert, die erkannte Temperatur zu minimieren, wobei der Algorithmus ausgewählt ist aus:
- einer systematischen Erkundung aller möglichen Werte der variablen Impedanzen des Impedanzanpassungs-Netzwerks und einer Beobachtung der Erhitzung der Ausgangsverstärkerstufe bei jedem Mal; und
- einem konvexen Optimierungsalgorithmus.

2. Verfahren nach Anspruch 1, **dadurch gekennzeichnet, dass** man zwei auf einer integrierten Schaltung platzierte Temperaturdetektoren verwendet, welche die Ausgangsverstärkerstufe enthält, wobei einer (TS1) in unmittelbarer Nähe dieser Stufe und der andere (TS2) weiter entfernt befindlich ist, um das Messsignal bereitzustellen, wobei Letzteres die Differenz zwischen der lokalen Temperatur der Verstärkerstufe und der durchschnittlichen Temperatur der integrierten Schaltung darstellt.

3. Sendekette, beinhaltend mindestens eine Ausgangsverstärkerstufe, eine Last und ein Impedanzanpassungs-Netzwerk, welches zwischen der Verstärkerstufe und der Last platziert ist und variable Impedanzen beinhaltet, eine Messschaltung, welche einen Temperaturdetektor (TS1) beinhaltet, welcher auf einer integrierten Schaltung platziert ist, welche die Ausgangsverstärkerstufe beinhaltet, in unmittelbarer Nähe von dieser Ausgangsstufe, sowie eine Steuerschaltung (CTRL) des Anpassungs-Netzwerks, wobei die Steuerschaltung konfiguriert ist, um am Eingang ein durch die Messschaltung erzeugtes Temperaturmesssignal zu empfangen, und um die Werte der variablen Impedanzen des Impedanzanpassungs-Netzwerks zum Variieren zu veranlassen, indem sie einen Suchalgorithmus von Werten der Impedanzen ausführt, welcher dazu tendiert, die gemessene Temperatur zu minimieren, wobei der Algorithmus ausgewählt ist aus:
- einer systematischen Erkundung aller möglichen Werte der variablen Impedanzen des Impedanzanpassungs-Netzwerks und einer Beobachtung der Erhitzung der Ausgangsverstärkerstufe bei jedem Mal; und
- einem konvexen Optimierungsalgorithmus.

4. Sendekette nach Anspruch 3, **dadurch gekennzeichnet, dass** sie einen zweiten Temperaturdetektor (TS2) beinhaltet, welcher auf derselben integrierten Schaltung platziert und von der Ausgangsstufe entfernt ist, wobei die Messschaltung ein Signal bereitstellt, welches die Differenz der durch die beiden Detektoren erkannten Temperaturen darstellt.

5. Sendekette nach einem der Ansprüche 3 und 4, **dadurch gekennzeichnet, dass** das Anpassungs-Netzwerk aus einer einfachen Montage mit drei Scheinimpedanzen in T- oder Pi-Schaltung besteht, wobei mindestens eine davon variabel ist.

## Claims

1. Method for matching the impedance of a transmission channel comprising an output amplifier stage connected to a load via an impedance matching network (MN) comprising variable impedances, the method comprising the following steps:
a temperature measuring signal generated by the operation of the output amplifier stage is produced, by means of a temperature detector (TS1) placed in the immediate vicinity of this stage, the measurement signal is supplied at the input of a circuit (CTRL) for controlling the variable impedances of the matching network, and said control circuit is used to vary the values of said variable impedances by executing an algorithm for searching for values of said impedances tending to minimize the temperature sensed, said algorithm being chosen from:
- a systematic exploration of all the possible values of the variable impedances of the impedance matching network and an observation of the heating of the output amplifier stage each time; and
- a convex optimization algorithm.

2. Method according to claim 1, **characterized in that** two temperature sensors are used placed on an integrated circuit which contains the output amplifier stage, one (TS1) in the immediate vicinity of this stage and the other (TS2) further on, to supply the measuring signal, the latter representing the difference between the local temperature of the amplifier stage and the average temperature of the integrated circuit.

3. The transmission channel comprising at least one output amplifier stage, a load, and an impedance matching network positioned between the amplifier stage and the load and comprising variable impedances, a measuring circuit comprising a temperature sensor (TS1) positioned on an integrated circuit comprising the output amplifier stage, in the immediate vicinity of this output stage, as well as a control circuit (CTRL) of the matching network, said control circuit being configured to receive as input a temperature measuring signal generated by said measurement circuit and to cause the values of said variable impedances of said impedance matching network to vary by executing an algorithm for searching for values of said impedances tending to minimize the measured temperature, said algorithm being chosen from:
- a systematic exploration of all the possible values of the variable impedances of the impedance matching network and an observation of the heating of the output amplifier stage each time; and
- a convex optimization algorithm.

4. The transmission channel according to claim 3, **characterized in that** it comprises a second temperature sensor (TS2) positioned on the same integrated circuit and distanced from the output stage, the measuring circuit supplying a signal representing the difference in the temperatures sensed by the two sensors.

5. Transmission channel according to one of claims 3 and 4, **characterized in that** the matching network is made up of a simple assembly with three reactive impedances in the form of a Te or Pi, at least one of which is variable.
